# EUROPÄISCHE PATENTSCHRIFT

(11) **EP 0 717 317 B1**
(45) Veröffentlichungstag und Bekanntmachung des Hinweises auf die Patenterteilung: **26.01.2000**
(21) Anmeldenummer: 95119337.4
(22) Anmeldetag: 07.12.1995
(51) Int. Cl.: G03F 7/004, C07C 69/02

(54) **Strahlungsempfindliches Gemisch**
Radiation-sensitive composition
Composition sensible aux rayonnements

(30) Priorität: 15.12.1994 DE 4444669
(43) Veröffentlichungstag der Anmeldung: 19.06.1996
(73) Patentinhaber: Clariant GmbH, 65929 Frankfurt am Main (DE); Agfa-Gevaert AG, 51373 Leverkusen (DE)
(72) Erfinder: Eichhorn, Mathias, Dr., D-65527 Niedernhausen (DE); Buhr, Gerhard, Dr., D-61462 Königstein (DE)

(56) Entgegenhaltungen:
- EP-A- 0 448 006
- EP-A- 0 525 626
- US-A- 5 133 894
- US-A- 5 175 348
- J. OF VACUUM SCI. AND TECHN. B, Bd. 9, Nr. 6, 1991, NEW YORK, Seiten 3387-3391, XP000268554 HIROSHI BAN ET AL.: "Metal-free chemically amplified positive resist resolving 0,2 micron in x-ray lithography"

## Beschreibung

Die Erfindung betrifft ein strahlungs-, insbesondere lichtempfindliches Gemisch, welches als wesentliche Bestandteile
a) eine Verbindung mit mindestens einer durch Säure spaltbaren C-O-C-Bindung und
b) eine Verbindung enthält, die unter Einwirkung von aktinischer Strahlung eine starke Säure bildet.

Positiv arbeitende lichtempfindliche Gemische, deren belichtete Stellen in einer wäßrig-alkalischen Entwicklerflüssigkeit leichter löslich sind als die unbelichteten Bereiche, sind bekannt. In der Praxis haben sich vor allem die positiv arbeitenden Aufzeichnungsmaterialien auf der Basis von o-Chinondiaziden durchgesetzt.

Die Lichtempfindlichkeit dieser Materialien befriedigt häufig nicht. Eine Steigerung der Lichtempfindlichkeit kann man durch Verwendung katalytisch wirksamer lichtempfindlicher Systeme erreichen, da hierbei die Quantenausbeute größer als 1 wird. So wurde das bekannte Prinzip, durch photolytisch erzeugte Säuren Folgereaktionen auszulösen und dadurch eine erhöhte Löslichkeit der belichteten Bereiche hervorzurufen, in neuerer Zeit für positiv arbeitende Systeme genutzt. Dabei dienen photochemisch erzeugte starke Säuren zur Spaltung säurelabiler Verbindungen, deren Spaltprodukte in wäßrig-alkalischen Entwicklern eine größere Löslichkeit als die Ursprungsverbindungen besitzen.

Als säurespaltbare Verbindungen werden nieder- und hochmolekulare Acetale und O,N-Acetale, die als Hydroxyl- oder Aminkomponente aromatische Verbindungen enthalten (US-A 3 779 778) sowie Orthoester und Amidacetale (DE-C 26 10 842) verwendet. Strahlungsempfindliche positiv arbeitende Gemische erhält man auch unter Verwendung von polymeren Orthoestern (EP-B 0 022 571) und polymeren aliphatischen Acetalen (DE-C 27 18 254). Derartige Gemische befriedigen häufig nicht, da die durch säurekatalysierte Fragmentierung erhaltenen Spaltprodukte oftmals nur unzureichend in wäßrigen Alkalien löslich sind und daher zu Problemen bei der Entwicklung solcher Schichten führen. Außerdem sind viele der genannten Verbindungen nur schwer zugänglich. In anderen Fällen ist die Lagerfähigkeit der entsprechenden Aufzeichnungsmaterialien im unbelichteten Zustand unbefriedigend.

Polymere mit säurelabilen tert.-Butylcarbonat- oder tert.-Butyl-carbonsäureestergruppierungen, welche im Gemisch mit photochemischen Säurespendern positiv arbeiten, sind in den EP-B 0 102 450 und 0 366 590 beschrieben. Eine Übertragung dieses Prinzips auf Moleküle mit einem Molgewicht unterhalb 500 in Kombination mit herkömmlichen Bindemitteln findet man in der EP-B 0 249 139. Derartige Systeme sind auch nicht frei von Nachteilen: Die gegenüber o-Chinondiaziden verringerte Löslichkeitsinhibierung der Bindemittelmatrix äußert sich in zu geringer Resistenz der unbelichteten Bereiche im Entwickler (sog. Dunkelabtrag) und damit einer schlechten Differenzierung zwischen belichteten und unbelichteten Bereichen.

Aufgabe der Erfindung war es, neue, strahlungsempfindliche Gemische mit hoher Empfindlichkeit für aktinische Strahlung, insbesondere kurzwelliges Licht bereitzustellen, die eine gute Differenzierung zwischen belichteten und unbelichteten Bereichen ermöglichen und eine hohe Lagerfähigkeit im unbelichteten Zustand aufweisen. Unter aktinischer Strahlung soll im Rahmen dieser Beschreibung jede Strahlung verstanden werden, deren Energie mindestens der des sichtbaren Lichts entspricht. Geeignet ist insbesondere langwellige UV-Strahlung, aber auch Elektronen-, Röntgen- und Laserstrahlung.

Die Erfindung geht aus von einem strahlungsempfindlichen Gemisch, welches als wesentliche Bestandteile
a) eine Verbindung mit mindestens einer durch Säure spaltbaren C-O-C-Bindung und
b) eine Verbindung enthält, die unter Einwirkung von aktinischer Strahlung eine starke Säure bildet.

Das erfindungsgemäße Gemisch ist dadurch gekennzeichnet, daß die Verbindung (a) eine Verbindung der Formel I 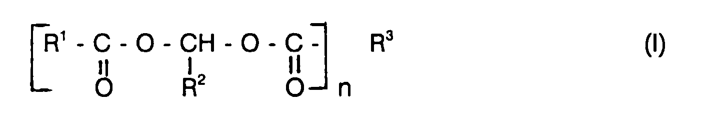 ist, worin
- R¹: einen ggf. substituierten Alkylrest,
- R²: ein Wasserstoffatom oder einen ggf. substituierten Alkylrest mit 1 bis 4 Kohlenstoffatomen
- R³: einen n-wertigen, ggf. polymeren aliphatischen oder aromatischen Rest und
- n: eine Zahl von 1 bis 100
bedeutet.

In den Verbindungen der Formel I kann der Rest R ein gesättigter oder ungesättigter linearer oder verzweigter substituierter oder unsubstituierter Alkylrest sein. Als Substituenten kommen Halogenatome, insbesondere Fluoratome, Alkoxygruppen mit 1 bis 4 Kohlenstoffatomen und Phenylreste in Betracht. Die Gesamtzahl der Kohlenstoffatome von R¹ sollte nicht größer als 10 sein. Besonders bevorzugt werden unsubstituierte lineare oder verzweigte Akylreste R¹ mit 1 bis 6, vor allem 1 bis 4 Kohlenstoffatomen, wobei sekundäre und tertiäre Alkylreste besonders vorteilhaft sind.

Der Rest R² ist bevorzugt ein Wasserstoffatom, eine Methyl- oder Ethylgruppe.

In den niedermolekularen Acylalen ist n eine Zahl von 1 bis 4, vorzugsweise 2 oder 3.

R³ kann eine niedermolekulare oder hochmolekulare Gruppe sein. Als niedermolekulare Gruppe kann R³ aliphatisch, cycloaliphatisch oder aromatisch sein. Bevorzugt werden Gruppen, die mindestens einen, bevorzugt 1 bis 3 aromatische Kerne, also Benzolringe, enthalten. Diese können untereinander durch Anellierung oder Verknüpfung durch ein Zwischenglied verbunden sein. das Zwischenglied kann u. a. eine Einfachbindung oder eine der Gruppen -O-, -S-, -SO-, -SO₂-, -SO₂-O-, -CO- oder -C(R⁴(R⁵)- sein, wobei R⁴ und R⁵ gleich oder verschieden sind und Wasserstoffatome, Methylgruppen oder Trifluormethylgruppen bedeuten. Die aromatischen Kerne können z. B. durch Halogenatome, Alkyl- oder Alkoxygruppen mit 1 bis 3 Kohlenstoffatomen, Alkanoyl- oder Alkoxycarbonylgruppen mit 2 bis 5 Kohlenstoffatomen oder Carboxygruppen substituiert sein.

Wenn R³ eine aliphatische Gruppe ist, hat diese im allgemeinen 1 bis 10, bevorzugt 1 bis 6 Kohlenstoffatome und kann durch Ethersauerstoffatome oder Phenylengruppen unterbrochen sein und Doppelbindungen enthalten. Als cycloaliphatische Gruppen R³ kommen bevorzugt solche mit 5 oder 6 Ringgliedern in Betracht; sie können einen oder zwei Ringe enthalten, die ggf. durch gleiche Zwischenglieder wie die aromatischen Ringe verknüpft sind.

Wenn R³ eine polymere Gruppe ist, kann diese bis zu etwa 100 Einheiten mit seitenständigen Carboxylgruppen enthalten und von einem Homo- oder Copolymeren abgeleitet sein. Als Comonomereinheiten sind nicht saure Vinylmonomereinheiten, z. B. aus Olefinen, Vinylethern, Vinylestern, (Meth)acrylsäureestern, Maleinsäureestern oder Vinylaromaten geeignet. Die Carbonsäureeinheiten können von α, β-ungesättigten Carbonsäuren, wie (Meth)acrylsäure, Maleinsäure bzw. Maleinsäureanhydrid, Crotonsäure, Vinylbenzoesäure und dgl. abgeleitet sein. Das Molekulargewicht des Carboxylgruppen enthaltenden Polymeren kann im Bereich von 5000 bis 200000, vorzugsweise von 20000 bis 100000 liegen. Copolymere von (Meth)acrylsäure mit (Meth)acrylsäureestern werden besonders bevorzugt.

Die säurespaltbaren Acylale werden vorzugsweise aus den zugrundeliegenden Carbonsäuren R³(COOH)ₙ durch Umsetzen mit Carbonsäureestern der Formel R¹ - CO - O - CHR²- X hergestellt, worin X ein Halogenatom, insbesondere Cl oder Br ist. Die Umsetzung erfolgt in Gegenwart organischer Basen, z. B. von 1,8-Diaza-bicyclo[5.4.0]undec-7-en (DBU). Besonders gut eignen sich die Ester mit R¹ = tert. Butyl, da bei ihnen durch die sterische Abschirmung der Carbonylgruppe die Tendenz zu Nebenreaktionen weitgehend unterdrückt ist. Die polymeren Acylale können auch durch Polymerisation von Acylalgruppen enthaltenden Monomeren hergestellt werden. Grundsätzlich können auch Polymere mit Acylalgruppen in der Hauptkette als säurespaltbare Verbindungen in den erfindungsgemäßen Gemischen eingesetzt werden.

Beispiele für geeignete Carbonsäureester R¹-CO-O-CHR²X sind Pivalinsäurechlormethylester und Pivalinsäure-1-bromethylester. Als Carbonsäuren R³(COOH)ₙ kommen in Frage: Aliphatische Mono- oder Polycarbonsäuren wie Hexansäure, Malonsäure, Propantricarbonsäure oder 1,2,3,4-Butantetracarbonsäure und cycloaliphatische Carbonsäuren wie 1,4-Cyclohexandicarbonsäure. Besonders bevorzugt sind aromatische Mono- und Polycarbonsäuren wie Benzoesäure, Phthalsäure, Isophthalsäure, Terephthalsäure, Benzol-1,3,5-tricarbonsäure, 1,2,4,5-Benzoltetracarbonsäure, Naphthalin-1-carbonsäure, Naphthalin-2-carbonsäure, Naphthalin-1,4-dicarbonsäure, Naphthalin-2,6-dicarbonsäure, Naphthalin-1 ,8-dicarbonsäure, Naphthalintricarbonsäuren, Naphthalin-1,4,5,8-tetracarbonsäure, Biphenyl-4-carbonsäure, Biphenyl-4,4'-dicarbonsäure, Diphenylether-4,4'-dicarbonsäure, Benzophenon-2-, -3- und -4-carbonsäure, Benzolsulfonsäurephenylester-4,4'-dicarbonsäure, Bis-(4-carboxyphenyl)-sulfon, Bis-(4-carboxyphenyl)-methan und 2,2-Bis-(4-carboxyphenyl)-propan. Im allgemeinen ist jede Mono- und Polycarbonsäure geeignet, die unter den gewählten Reaktionsbedingungen einerseits nukleophil genug ist, die gewünschte Umsetzung zum Acylal einzugehen und andererseits außer Carbonsäuregruppen keine weiteren, unter den gewählten Reaktionsbedingungen zur Umsetzung mit Carbonsäureestern R¹CO-O-CHR²X befähigten Gruppen enthält.

Zur Herstellung der erfindungsgemäßen positiv arbeitenden, strahlungsempfindlichen Gemische werden die beschriebenen hoch- oder niedermolekularen Acylale der allgemeinen Formel

[R¹CO-O-CHR²-O-CO-]ₙR³

gemischt mit Substanzen, die photochemisch bzw. durch Einwirken energiereicher Strahlen Säure bilden, sowie ggf. mit Bindemitteln. Der Mengenanteil der Acylale am Gesamtfeststoff der Gemische kann dabei zwischen 10 und 95, bevorzugt bei 30 bis 90 Gew.-%; bei Verwendung von Bindemitteln zwischen 5 und 50, vorzugsweise zwischen 10 und 30 Gew.-% liegen. Durch Verwendung unterschiedlicher Acylale bzw. von Gemischen derselben lassen sich die stofflichen Eigenschaften der damit hergestellten Aufzeichnungsmaterialien breit variieren. Da sich als Entwicklerflüssigkeit für die belichteten Kopierschichten mit Vorteil wäßrig-alkalische Lösungen einsetzen lassen und diese im allgemeinen den Entwicklern auf Basis organischer Lösemittel vorgezogen werden, sind insbesondere solche Bindemittel bevorzugt, die in wäßrigen Alkalien löslich oder zumindest quellbar sind.

Als Bindemittel besonders geeignet sind die in vielen Positiv-Kopiermaterialien eingesetzten Phenolharze, insbesondere Kresol-Formaldehyd-Novolake (Schmelzbereich 105 - 120 °C nach DIN 53181) und Phenol-Formaldehyd-Novolake (Schmelzbereich 110 - 120 °C nach DIN 53181). Ebenso sind Polymere mit phenolischen OH-Gruppen, z. B. Polyhydroxystyrol und dessen Copolymere mit neutralen aliphatischen oder aromatischen Monomeren geeignet.

Die Art und Menge der wasserunlöslichen Bindemittel kann je nach Anwendungszweck verschieden sein; im allgemeinen liegt ihr Anteil am Gesamtfeststoff zwischen 0 und 95, bevorzugt bei 20 bis 90 Gew.-%. Wenn das säurespaltbare Acylal selbst nicht polymer ist, werden zumeist 50 bis 95, bevorzugt 70 bis 90 Gew.-% Bindemittel eingesetzt.

Für den Einsatz in dem erfindungsgemäßen Gemisch ebenfalls geeignet sind Bindemittel, deren Alkalilöslichkeit durch Einwirkung von Säure erhöht wird. Solche Bindemittel können z. B. hergestellt werden, indem die phenolischen OH-Gruppen handelsüblicher Polyhydroxystyrol-Bindemittel mit säurelabilen Gruppierungen versehen werden, die die Alkalilöslichkeit verringern.

Andere alkalilösliche Harze wie Mischpolymerisate aus Methacrylsäure und Methylmethacrylat, Vinylacetat und Crotonsäure, Maleinsäureanhydrid und Styrol und dgl. sind jedoch als Bindemittel ebenfalls geeignet.

Zur Herstellung der erfindungsgemäßen strahlungsempfindlichen Gemische werden die säurespaltbaren, Acylalgruppen enthaltenden Verbindungen mit dem Bindemittel sowie mit Substanzen, die photochemisch bzw. durch Einwirken energiereicher Strahlen eine starke Säure bilden, gemischt. Der Zusatz eines Bindemittels ist dann nicht erforderlich, wenn das Acylal selbst polymer ist. In diesem Fall kann das polymere Acylal freie Carboxylgruppen enthalten; dies ist jedoch nicht erforderlich, da bei der lichtinduzierten Spaltung der Acylalgruppen genügend freie Carboxylgruppen gebildet werden, um das Belichtungsprodukt alkalilöslich zu machen.

Zusätzlich können in den erfindungsgemäßen strahlungsempfindlichen Gemischen noch zahlreiche andere Polymere mitverwendet werden, bevorzugt Vinylpolymerisate wie Polyvinylacetate, Poly(meth)acrylate, Polyvinylether und Polyvinylpyrrolidone, die selbst durch Comonomere modifiziert sein können. Der günstigste Anteil an diesen Polymeren richtet sich nach den anwendungstechnischen Erfordernissen und dem Einfluß auf die Entwicklungsbedingungen und beträgt im allgemeinen nicht mehr als 20 % vom Gesamtfeststoffgehalt. In geringen Mengen kann die lichtempfindliche Schicht für spezielle Erfordernisse wie Flexibilität, Haftung, Glanz etc. außerdem noch Substanzen wie Polyglykole, Cellulosederivate wie Ethylcellulose, Netzmittel, Farbstoffe und feinteilige Pigmente enthalten.

Als strahlungsempfindliche Komponenten, die beim Bestrahlen vorzugsweise starke Säuren bilden bzw. abspalten, sind zur Verwendung in den erfindungsgemäßen strahlungsempfindlichen Gemischen eine große Anzahl von bekannten Verbindungen und Mischungen, wie Onium-, z. B. Diazonium-, Phosphonium-, Sulfonium- und lodoniumsalze; Halogenverbindungen; o-Chinondiazidsulfochloride, -ester und -amide sowie Organometall/Organohalogen-Kombinationen geeignet.

Die genannten Oniumverbindungen werden in der Regel eingesetzt in Form ihrer in organischen Lösemitteln löslichen Salze, z. B. der Sulfonate, Trifluormethansulfonate und Hexafluorpropansulfonate, oder als Abscheidungsprodukte mit komplexen Säure wie Tetrafluorobor-, Hexafluorophosphor-, -antimon- und -arsensäure, wobei die Diazoniumsalze besonders bevorzugt werden.

Es können aber auch Halogenide, Ester und Amide der positiv arbeitenden o-Chinondiazide verwendet werden. Bevorzugt wird aus dieser Gruppe das Naphthochinon-1 ,2-diazid-(2)-4-sulfochlorid.

Grundsätzlich sind als halogenhaltige strahlungsempfindliche und Halogenwasserstoffsäure bildende Verbindungen alle auch als photochemische Radikalstarter bekannten organischen Halogenverbindungen brauchbar, beispielsweise solche mit mehr als einem Halogenatom an einem Kohlenstoffatom oder an einem aromatischen Ring. Beispiele sind in der US-A 3 779 778, der DE-C 26 10 842 und den DE-A 27 18 259 und 22 43 621 beschrieben. Die Empfindlichkeit dieser halogenhaltigen Verbindungen kann durch die bekannten Sensibilisatoren spektral beeinflußt und gesteigert werden.

Beispiele für besonders geeignete Säurespender zur Verwendung in dem erfindungsgemäßen strahlungsempfindlichen Gemisch sind: Naphthochinon-1,2-diazid-(2)-4-sulfochlorid; 4-(Di-n-propylamino)-benzoldiazonium-tetrafluoroborat, -hexafluorophosphat und -trifluormethansulfonat; 2,5-Diethoxy-4-(4-tolylmercapto)-benzoldiazonium-tetrafluoroborat, -hexafluorophosphat, -trifluormethansulfonat und -hexafluorpropansulfonat; Diphenylamin-4-diazoniumsulfat und 4-Diethylamino-benzoldiazonium-trifluormethansulfonat sowie die in den Beispielen angeführten Verbindungen. Ebenfalls verwendet werden könnnen 4-Methyl-6-trichlormethyl-2-pyron;4-(3,4,5-Trimethoxystyryl)-6-trichlormethyl-2-pyron;2-Trichlormethylbenzimidazol; 2-Tribrommethyl-chinolon; 2,4-Dimethyl-1-tribromacetyl-benzol; 3-Nitro-1-tribromacetyl-benzol, 4,6-Bis-trichlormethyl-s-triazine wie 2-(6-Methoxynaphth-2-yl)-, 2-(Naphth-1-yl)-, 2-(4-Ethoxyethyl-napth-1-yl)-, 2-(Benzopyran-3-yl)-, 2-(Phenanthr-9-yl)- und 2-(4-Methoxy-antrac-1-yl)-4,6-bis-trichlormethyl-s-triazin.

Die Menge des Starters kann je nach seiner chemischen Natur und der Zusammensetzung des Gemischs ebenfalls sehr unterschiedlich sein. Im allgemeinen werden etwa 0,1 bis 40 Gew.-%, bezogen auf den Gesamtfeststoff, bevorzugt 0,2 bis 25 Gew.-%, eingesetzt. Besonders für Schichten von Dicken über 10 µm empfiehlt es sich, relativ wenig Säurespender zu verwenden.

Schließlich können den lichtempfindlichen Gemischen noch lösliche oder auch feinteilige dispergierbare Farbstoffe sowie je nach Verwendungszweck auch UV-Absorber zugesetzt werden. Als Farbstoffe haben sich die Triphenylmethanfarbstoffe, insbesondere in Form ihrer Carbinolbasen, besonders bewährt. Die günstigsten Mengenverhältnisse der Komponenten lassen sich im Einzelfall durch Vorversuche leicht ermitteln.

Geeignete Lösemittel für das erfindungsgemäße strahlungsempfindliche Gemisch sind Ketone wie Methylethylketon, chlorierte Kohlenwasserstoffe wie Trichlorethylen und 1,1,1-Trichlorethan, Alkohole wie n-Propanol, Ether wie Tetrahydrofuran, Alkoholether wie Propylen- oder Ethylenglykolmonomethylether und Ester wie Butylacetat. Es können auch Gemische verwendet werden, die zudem noch für spezielle Zwecke Lösemittel wie Acetonitril, Dioxan oder Dimethylformamid enthalten können. Prinzipiell sind alle Lösemittel verwendbar, die mit den Schichtkomponenten nicht irreversibel reagieren.

Im Vergleich zu anderen Positivschichten, besonders denen auf o-Naphthochinondiazidbasis, ist die Herstellung dickerer Schichten vorteilhaft möglich, da die Lichtempfindlichkeit der erfindungsgemäßen Gemische verhältnismäßig wenig dickenabhängig ist. Belichtung und Verarbeitung von Schichtdicken bis ca. 100 µm und darüber ist möglich.

Bevorzugte Träger für Schichten von mehr als 10 µm Dicke sind Kunststoffolien, die dann als temporäre Träger für Transferschichten dienen. Dafür und für Farbfolien werden Polyesterfolien, z. B. aus Polyethylenterephthalat, bevorzugt. Polyolefin-, z. B. Polypropylenfolien sind ebenfalls geeignet. Als Schichtträger für Schichtdicken unter ca. 10 µm werden meist Metalle verwendet. Für Offsetdruckplatten können eingesetzt werden: Mechanisch oder elektrochemisch aufgerauhtes und ggf. anodisiertes Aluminium, das zudem noch chemisch, z. B. mit Polyvinylphosphonsäure, Silikaten oder Phosphaten, vorbehandelt sein kann, außerdem Mehrmetallplatten mit Cu/Cr oder Messing/Cr als oberster Schicht. Für Hochdruckplatten können die erfindungsgemäßen Gemische auf Zink- oder Magnesiumplatten sowie deren handelsübliche mikrokristalline Legierungen für Einstufenätzverfahren aufgetragen werden, außerdem auf ätzbare Kunststoffe wie Polyoxymethylen. Für Tiefdruck- oder Siebdruckformen eignen sich die erfindungsgemäßen Gemische durch ihre gute Haftung und Ätzfestigkeit auf Kupfer- bzw. Nickeloberflächen. Ebenso lassen sie sich als Photoresists und beim Formteilätzen verwenden.

Die Beschichtung kann direkt oder durch trockene Schichtübertragung vom temporären Träger erfolgen auf Leiterplattenmaterialien, die aus Isolierplatten mit ein- oder beidseitiger Kupferauflage bestehen, auf Glas- oder Keramikmaterialien, die ggf. haftvermittelnd vorbehandelt sind, und u. a. auf Siliziumscheiben, auf deren Oberfläche sich ggf. eine Nitrid- oder Oxidschicht befindet. Außerdem können Holz, Textilien und Oberflächen vieler Werkstoffe beschichtet werden, die vorteilhaft durch Projektion bebildert werden und resistent gegen die Einwirkung alkalischer Entwickler sind.

Für die Trocknung nach dem Beschichten können die üblichen Geräte und Bedingungen übernommen werden; Temperaturen um 100 °C und kurzfristig bis 120 °C werden ohne Einbuße an Strahlungsempfindlichkeit vertragen.

Zum Belichten können die üblichen Lichtquellen wie Röhrenlampen, Xenonimpulslampen, metallhalogeniddotierte Quecksilberdampf-Hochdrucklampen und Kohlenbogenlampen verwendet werden. Darüber hinaus ist das Belichten in üblichen Projektions- und Vergrößerungsgeräten unter dem Licht von Metallfadenlampen sowie Kontaktbelichtung mit gewöhnlichen Glühbirnen möglich. Die Belichtung kann auch mit dem kohärenten Licht eines Lasers erfolgen. Geeignet für die Zwecke vorliegender Erfindung sind leistungsgerechte Laser, die im UV- oder sichtbaren Bereich emittieren, z. B. Argon-lonen-Laser, Krypton-lonen-Laser, Farbstoff-Laser, Helium-Cadmium-Laser sowie Excimer-Laser. Der Laserstrahl wird mittels einer vorgegebenen programmierten Strich- und/oder Rasterbewegung gesteuert.

Das Bestrahlen mit Elektronenstrahlen ist eine weitere Bebilderungsmöglichkeit. Elektronenstrahlen können das erfindungsgemäße Gemisch wie auch viele andere organische Materialien durchgreifend zersetzen und vernetzen, so daß ein negatives Bild entsteht, wenn die unbestrahlten Teile durch Lösemittel oder Belichten ohne Vorlage und Entwickeln entfernt werden. Bei geringerer Intensität und/oder höherer Schreibgeschwindigkeit des Elektronenstrahls bewirkt dagegen der Elektronenstrahl eine Differenzierung in Richtung höherer Löslichkeit, d. h. die bestrahlten Schichtpartien können vom Entwickler entfernt werden. Die Wahl der günstigsten Bedingungen kann durch Vorversuche leicht ermittelt werden.

Die bildmäßig belichtete oder bestrahlte Schicht kann - ggf. nach einer thermischen Nachbehandlung - mit praktisch den gleichen Entwicklern wie für handelsübliche Naphthochinondiazidschichten und Kopierlacke entfernt werden, bzw. die neuen Schichten können in ihren Kopierbedingungen vorteilhaft auf die bekannten Hilfsmittel wie Entwickler und programmierte Sprühentwicklungsgeräte abgestimmt werden. Die wäßrigen Entwicklerlösungen können z. B. Alkaliphosphate, -silikate oder -hydroxide und ferner Netzmittel sowie kleinere Anteile organischer Lösemittel enthalten. In bestimmten Fällen sind auch reines Wasser oder Lösemittel/Wasser-Gemische als Entwickler brauchbar. Der günstigste Entwickler kann durch Versuche mit der jeweils verwendeten Schicht ermittelt werden. Bei Bedarf kann die Entwicklung mechanisch unterstützt werden. Zur Erhöhung der Widerstandsfähigkeit beim Druck sowie der Resistenz gegen Auswaschmittel, Korrekturmittel und durch UV-Licht härtbare Druckfarben können die entwickelten Platten kurze Zeit auf erhöhte Temperaturen erwärmt werden, wie es für Diazoschichten aus der GB-A 1 154 749 bekannt ist.

Im folgenden werden Beispiele für bevorzugte erfindungsgemäße strahlungsempfindliche Gemische und eine Synthese der in ihnen enthaltenen, säurespaltbaren Acylale angegeben. Die Mengen sind in Gewichtsteilen (Gt) angegeben, Prozente und Mengenverhältnisse in Gewichtseinheiten zu verstehen.

### Beispiele 1 - 12

### Umsetzung von Carbonsäuren mit Pivalinsäureestern zu Acylalen

1 Äquivalent der Carbonsäure wurde in Aceton gelöst bzw. suspendiert. Je Carbonsäureeinheit wurden 1,1 Äquivalente Pivalinsäurechlormethylester bzw. Pivalinsäure-1-brom-ethylester zugegeben. Anschließend wurden bei 0 °C je Carbonsäureeinheit 1,1 Äquivalente 1,8-Diazabicyclo[5.4.0]undec-7-en (DBU) zugetropft. Es wurde noch einige Zeit bei Raumtemperatur, ggf. bei leicht erhöhter Temperatur, bis zur beendeten Umsetzung (durch Dünnschichtchromatographie) nachgerührt. Nach Absaugen des ausgefallenen DBU-Chlorids bzw. -Bromids wurde das Lösemittel im Rotationsverdampfer abdestilliert, der Rückstand in Essigsäureethylester aufgenommen und die Lösung nacheinander mit 0,1n HCI, NaHCO₃-Lösung und H₂O ausgewaschen. Nach Trocknen mit MgSO₄ wurde eingeengt und ggf. umkristallisiert. Es wurden die in Tabelle 1 aufgeführten Acylale erhalten.

**Tabelle 1:**

| **Synthetisierte Acylale der allgemeinen Formel I mit R**^{**1**} **= tert. Butyl** | | | | |
|---|---|---|---|---|
| **Nr.** | **R**^{**2**} | **R**^{**3**} | **Fp[°C]** | **n** |
| 1 | H | 4,4'-Oxy-diphenyl | 74 - 75 | 2 |
| 2 | CH₃ | | 86 - 88 | 2 |
| 3 | H | 1,3,5-Benzoltriyl | 75 - 77 | 3 |
| 4 | CH₃ | | 103 - 104 | 3 |
| 5 | H | 1,4-Phenylen | 88 - 89 | 2 |
| 6 | CH₃ | | 105 - 106 | 2 |
| 7 | H | 4-Benzoyl-phenyl | 70 - 71 | 1 |
| 8 | CH₃ | | 63 - 64 | 1 |
| 9 | CH₃ | 4,4'-Sulfonyl-diphenyl (-C₆H₄-SO₂-C₆H₄-) | 88 - 91 | 2 |
| 10 | CH₃ | 4,4'-Sulfonyloxy-diphenyl (-C₆H₄-SO₂O-C₆H₄-) | 110 - 114 | 2 |
| 11 | H | Biphenyl-4,4'-diyl | 118 - 119 | 2 |
| 12 | CH₃ | | 150 - 153 | 2 |

### Beispiel 13

Die in Tabelle 1 enthaltenen Verbindungen wurden zu Lösungen der Zusammensetzung
- 5,00 Gt: Novolak,
- 1,50 Gt: Acylal gemäß Tabelle 1,
- 0,25 Gt: 4-p-Tolylmercapto-2,5-diethoxy-benzoldiazonium-hexafluorophosphat und
- 0,03 Gt: Kristallviolettbase in
- 125 Gt: Butanon
verarbeitet und auf Platten aus elektrochemisch aufgerauhtem und anodisiertem Aluminum durch Schleudern aufgebracht und bei 100 °C im Trockenschrank getrocknet, wobei eine Schichtdicke von 1,8 bis 2,0 µm resultierte. Die Platten wurden unter einer 5 kW-Metallhalogenidlampe 30 s im Abstand von 110 cm durch einen Halbtonstufenkeil mit 13 Stufen einer Dichteabstufung von 0,15 belichtet, 2 Minuten im Trockenschrank auf 120 °C erwärmt und in einem wäßrig-alkalischen Entwickler der Zusammensetzung
- 5,5 Gt: Natriummetasilikat x 9 H₂O,
- 3,4 Gt: Trinatriumphosphat x 12 H₂O,
- 0,4 Gt: Mononatriumphosphat, wasserfrei und
- 90,7 Gt: vollentsalztes Wasser
entwickelt. Es wurden positive Abbilder der Filmvorlage erhalten.

### Beispiel 14

Dieses Beispiel zeigt die Eignung der erfindungsgemäßen strahlungsempfindlichen Gemische zur Verwendung in Offsetdruckplatten.

Eine Platte aus elektrochemisch aufgerauhtem und anodisiertem Aluminium wurde mit einer Lösung aus
- 5,00 Gt: Novolak,
- 1,50 Gt: Acylal 10 gemäß Tabelle 1,
- 0,25 Gt: 4-p-Tolylmercapto-2,5-diethoxy-benzoldiazonium-1,1,2,3,3,3-hexafluor-propansulfonat und
- 0,03 Gt: Kristallviolettbase in
- 125 Gt: Butanon
beschichtet und im Trockenschrank auf 100 °C erhitzt, wobei eine Schichtdicke von 1,9 µm resultierte. Die Platte wurde unter einer 5 kW Metallhalogenidlampe 30 s im Abstand von 110 cm durch einen Halbtonstufenkeil mit 13 Stufen einer Dichteabstufung von 0,15 belichtet, 3 Minuten auf 150 °C erwärmt und in dem in Beispiel 13 angegebenen Entwickler 30 s entwickelt. Es wurde ein positives Abbild der Filmvorlage erhalten; Stufe 4 des Halbtonstufenkeils war vollständig offen, Stufe 10 vollständig gedeckt wiedergegeben. In eine Offsetdruckmaschine eingespannt, wurden mit dieser Platte mehr als 60000 gute Drucke ohne erkennbare Abnutzung der Druckschicht erhalten.

### Beispiel 15

5 Gt eines Copolymeren aus Methylmethacrylat und Methacrylsäure (SZ 355, entsprechend 60 mol-% Methacrylsäure) wurden in 50 Gt Dimethylacetamid gelöst. Es wurden 14,5 Gt Pivalinsäure-1-bromethylester hinzugegeben und anschließend bei 0 °C 10,5 Gt DBU zugetropft. Nach 2 Stunden bei 50 °C wurde in H₂O gefällt und nochmals aus Aceton/H₂O umgefällt. Es wurden 6,2 Gt schwach gelb gefärbter Feststoff erhalten, in dem sich keine freien Säuregruppen nachweisen ließen.

### Beispiel 16

Eine Platte aus elektrochemisch aufgerauhtem und anodisiertem Aluminium wurde mit einer Lösung aus
- 9,00 Gt: Polymerem gemäß Beispiel 15,
- 2,50 Gt: der in Beispiel 14 angegebenen Diazoverbindung und
- 0,08 Gt: Kristallviolettbase in
- 175 Gt: Butanon
schleuderbeschichtet und im Trockenschrank auf 100 °C erhitzt, wobei eine Schichtdicke von 1,9 µm resultierte. Die Platte wurde unter einer 5 kW Metallhalogenidlampe 30 s im Abstand von 110 cm durch einen Halbtonstufenkeil mit 13 Stufen einer Dichteabstufung von 0,15 belichtet, 2 Minuten auf 100 °C erwärmt und in dem in Beispiel 13 angegebenen Entwickler 60 s entwickelt. Es wurde ein positives Abbild der Filmvorlage erhalten; Stufe 4 des Halbtonstufenkeils war vollständig offen, Stufe 10 vollständig gedeckt wiedergegeben. Eine zum Vergleich herangezogene Standard-Positivdruckplatte ®Ozasol P 61 (Hoechst AG) mußte zur Erzielung des gleichen Ergebnisses 70 s belichtet werden.

### Beispiel 17

Die beschichtete Aluminiumplatte gemäß Beispiel 16 wurde unter einer 5 kW-Metallhalogenidlampe 30 s im Abstand von 110 cm durch einen Halbtonstufenkeil mit 13 Stufen einer Dichteabstufung von 0,15 belichtet, 2 Minuten auf 120 °C erwärmt und durch Abreiben mit einem wasserfeuchten Schwamm entwickelt. Es wurde ein einwandfreies Abbild der Filmvorlage erhalten; Stufe 2 des Halbtonstufenkeils war vollständig offen, Stufe 6 vollständig gedeckt wiedergegeben.

## Patentansprüche

1. Strahlungsempfindliches Gemisch, das als wesentliche Bestandteile
a) eine Verbindung mit mindestens einer durch Säure spaltbaren C-O-C-Bindung und
b) eine Verbindung enthält, die unter Einwirkung von aktinischer Strahlung eine starke Säure bildet,
dadurch gekennzeichnet, daß die Verbindung (a) eine Verbindung der Formel I 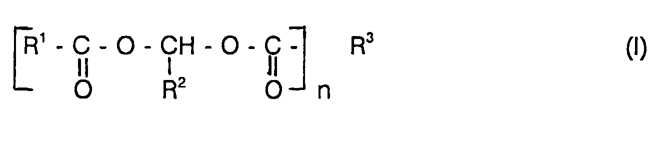 ist, worin
R¹ einen ggf. substituierten Alkylrest,
R² ein Wasserstoffatom oder einen ggf. substituierten Alkylrest mit 1 bis 4 Kohlenstoffatomen
R³ einen n-wertigen, ggf. polymeren aliphatischen oder aromatischen Rest und
n eine Zahl von 1 bis 100
bedeutet.

2. Strahlungsempfindliches Gemisch nach Anspruch 1, dadurch gekennzeichnet, daß R³ ein 1 bis 3 aromatische Kerne enthaltender Rest und n eine Zahl von 1 bis 4 ist.

3. Strahlungsempfindliches Gemisch nach Anspruch 1, dadurch gekennzeichnet, daß R¹ ein Alkylrest mit 1 bis 6 Kohlenstoffatomen ist.

4. Strahlungsempfindliches Gemisch nach Anspruch 1, dadurch gekennzeichnet, daß R² ein Wasserstoffatom oder eine Methylgruppe ist.

5. Strahlungsempfindliches Gemisch nach Anspruch 1, dadurch gekennzeichnet, daß R³ der Rest eines Carboxylgruppen enthaltenden Polymeren ist.

6. Strahlungsempfindliches Gemisch nach Anspruch 2, dadurch gekennzeichnet, daß es zusätzlich
c) ein polymeres, wasserunlösliches, in wäßrig-alkalischen Lösungen lösliches oder quellbares Bindemittel
enthält.

7. Strahlungsempfindliches Gemisch nach Anspruch 1, dadurch gekennzeichnet, daß die Verbindung (b) ein Oniumsalz ist.

8. Strahlungsempfindliches Gemisch nach einem der Ansprüche 1 bis 7, dadurch gekennzeichnet, daß es 5 bis 90 Gew.-% säurespaltbare Verbindung (a), 0,1 bis 40 Gew.-% säurebildende Verbindung (b) und 0 bis 90 Gew.-% alkalilösliches Bindemittel (c) enthält.

## Claims

1. A radiation-sensitive mixture which contains, as essential constituents,
a) a compound having at least one acid-cleavable C-O-C bond and
b) a compound which forms a strong acid on exposure to actinic radiation,
wherein the compound (a) is a compound of the formula I 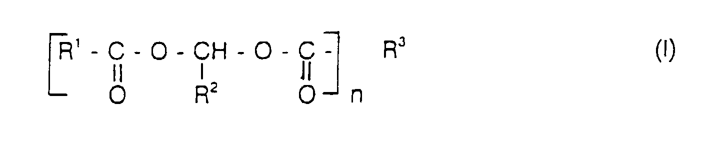 where
R¹ is an optionally substituted alkyl radical,
R² is a hydrogen atom or an optionally substituted alkyl radical containing 1 to 4 carbon atoms,
R³ is an n-valent, optionally polymeric aliphatic or aromatic radical and
n is a number from 1 to 100.

2. The radiation-sensitive mixture as claimed in claim 1, wherein R³ is a radical containing 1 to 3 aromatic nuclei and n is a number from 1 to 4.

3. The radiation-sensitive mixture as claimed in claim 1, wherein R¹ is an alkyl radical containing 1 to 6 carbon atoms.

4. The radiation-sensitive mixture as claimed in claim 1, wherein R² is a hydrogen atom or a methyl group.

5. The radiation-sensitive mixture as claimed in claim 1, wherein R³ is the radical of a polymer containing carboxyl groups.

6. The radiation-sensitive mixture as claimed in claim 2, which additionally contains
c) a polymeric water-insoluble binder which is soluble or swellable in aqueous alkaline solutions.

7. The radiation-sensitive mixture as claimed in claim 1, wherein the compound (b) is an onium salt.

8. The radiation-sensitive mixture as claimed in any of claims 1 to 7, which contains 5 to 90% by weight of acid-cleavable compound (a), 0.1 to 40% by weight of acid-forming compound (b) and 0 to 90% by weight of alkali-soluble binder (c).

## Revendications

1. Mélange sensible au rayonnement, contenant en tant que constituants essentiels
a) un composé comportant au moins une liaison C-O-C dissociable par un acide et
b) un composé lequel forme un acide fort sous l'effet d'un rayonnement actinique,
caractérisé en ce que le composé (a) est un composé de formule I 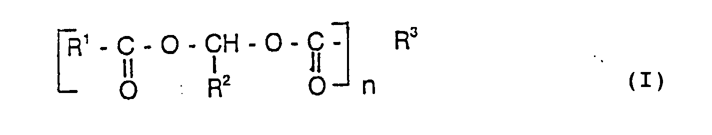 où
R¹ représente un reste alkyle éventuellement substitué,
R² représente un atome d'hydrogène ou un reste alkyle éventuellement substitué comportant 1 à 4 atomes de carbone,
R³ représente un reste aliphatique ou aromatique à fonctionnalité n, éventuellement polymère et
n va de 1 à 100.

2. Mélange sensible au rayonnement selon la revendication 1, caractérisé en ce que R³ représente un reste présentant 1 à 3 noyaux aromatiques et n est un nombre de 1 à 4.

3. Mélange sensible au rayonnement selon la revendication 1, caractérisé en ce que R¹ représente un reste alkyle comportant 1 à 6 atomes de carbone.

4. Mélange sensible au rayonnement selon la revendication 1, caractérisé en ce que R² représente un atome d'hydrogène ou un groupe méthyle.

5. Mélange sensible au rayonnement selon la revendication 1, caractérisé en ce que R³ représente un reste d'un polymère contenant des groupes carboxyle.

6. Mélange sensible au rayonnement selon la revendication 2, caractérisé en ce que qu'il contient de plus
c) un liant polymère, insoluble dans l'eau, soluble ou gonflable dans des solutions aqueuses-alcalines.

7. Mélange sensible au rayonnement selon la revendication 1, caractérisé en ce que le composé (b) est un sel d'onium.

8. Mélange sensible au rayonnement selon la revendication 1 à 7, caractérisé en ce que qu'il contient de 5 à 90% en masse de composé dissociable par un acide (a), de 0,1 à 40% en masse de composé formant un acide (b) et de 0 à 90% en masse d'un liant soluble en milieu alcalin (c).
